# EUROPEAN PATENT APPLICATION

(11) **EP 4 501 494 A1**
(43) Date of publication of application: **05.02.2025**
(21) Application number: 23781031.2
(22) Date of filing: 31.03.2023
(51) Int. Cl.: B22F 1/00, B22F 1/054, B22F 1/06, B22F 1/07, B22F 1/102, B22F 1/103, B22F 1/16, B22F 7/08, B22F 9/00, B22F 9/20, B82Y 30/00, B82Y 40/00, C22C 1/04, C22C 32/00, H01L 21/52

(54) **OXIDE-CONTAINING COPPER PARTICLES, PASTE COMPOSITION, SEMICONDUCTOR DEVICE, ELECTRICAL COMPONENT AND ELECTRONIC COMPONENT**

(30) Priority: 31.03.2022 JP 2022061331; 19.10.2022 JP 2022167366; 19.10.2022 JP 2022167371
(71) Applicant: Kyocera Corporation, Kyoto-shi, Kyoto 612-8501 (JP)
(72) Inventor: NONOMURA, Kouki, Kyoto-shi, Kyoto 612-8501 (JP); KIKUCHI, Tomonao, Kyoto-shi, Kyoto 612-8501 (JP)
(74) Representative: Viering, Jentschura & Partner mbB Patent- und Rechtsanwälte
(86) International application number: PCT/JP2023/013459
(87) International publication number: WO 2023/191023

(57) **Abstract**

Provided are an oxide-containing copper particle that can provide a paste composition capable of forming a bonding layer having high denseness, high bonding strength, and high bonding reliability, a paste composition including the same, and a semiconductor device, an electrical component, and an electronic component. In the oxide-containing copper particle of the present disclosure, an absorption spectrum of the oxide-containing copper particles dispersed in 1 × 10⁶ times by mass of ethanol, as measured by a spectrophotometer, has an absorption peak in a range of wavelengths of from 600 to 1000 nm.

## Description

### TECHNICAL FIELD

The present disclosure relates to an oxide-containing copper particle, a paste composition including the same, and a semiconductor device, an electrical component, and an electronic component.

### BACKGROUND OF INVENTION

In semiconductor devices and various electrical components and electronic components, a highly thermally conductive paste is used as an adhesive for bonding members. In a semiconductor device, heat generation is increased due to high integration and high-speed operation. A countermeasure for obtaining stable operability is adopted, for example, in which a heat generating member such as a semiconductor element and a heat dissipating member are bonded to each other with a highly thermally conductive adhesive (paste), whereby heat is dissipated. An electrically conductive paste having high thermal conductivity is used in die bonding of a bare chip, adhesion of an LED chip, adhesion between an electrode and a lead wire, and the like.

As one of electrically conductive pastes having high thermal conductivity, a paste composition containing a copper particle has been proposed. Application of such a paste composition to printed electronics has also been studied. For example, Patent Documents 1 and 2 disclose that an oxide-containing copper particle obtained by sintering a copper raw material at a low temperature is used as a constituent material for an electrically conductive paste.

### CITATION LIST

### PATENT LITERATURE

Patent Document 1: JP 2020-29392 A
Patent Document 2: WO 2022/045252

### SUMMARY

The present disclosure relates to the following:
[1] An oxide-containing copper particle, in which an absorption spectrum of the oxide-containing copper particles dispersed in 1 × 10⁶ times by mass of ethanol, as measured by a spectrophotometer, has an absorption peak in a range of wavelengths of from 600 to 1000 nm.

### BRIEF DESCRIPTION OF THE DRAWINGS

FIG. 1 is an absorption spectrum of an oxide-containing copper particle of Example 4.
FIG. 2 is an absorption spectrum of an oxide-containing copper particle of Comparative Example 2.
FIG. 3 is a scanning electron microscope observation image of the oxide-containing copper particle of Example 4.
FIG. 4 is a scanning electron microscope observation image of the oxide-containing copper particle of Comparative Example 2.

### DESCRIPTION OF EMBODIMENTS

The electrically conductive pastes including the oxide-containing copper particle, as described in Patent Documents 1 and 2, are substantially spherical particles. For this reason, when bonding is performed by sintering, there is a possibility that vacancies are generated in the bonding layer, resulting in low denseness, difficulty in obtaining sufficient bonding strength, and low bonding reliability.

The present disclosure relates to an oxide-containing copper particle that can provide a paste composition capable of forming a bonding layer having high denseness, high bonding strength, and high bonding reliability, a paste composition including the same, and a semiconductor device, an electrical component, and an electronic component.

Hereinafter, the present disclosure will be described in detail with reference to an embodiment.
The oxide-containing copper particle in the present disclosure refers to a particle containing metallic copper and at least one copper oxide. Hereinafter, it is also simply referred to as copper particle.

In the present description, wording of "from XX to YY" refers to "not less than XX and not more than YY". In the present description, with regard to numerical ranges (e.g., ranges such as content), lower and upper limit values described in a stepwise manner may each be independently combined. In a numerical range described herein, the upper or lower limit value of the numerical range may be replaced by a value presented in the examples.

### Oxide-Containing Copper Particle

In the oxide-containing copper particle of the present disclosure, an absorption spectrum of the oxide-containing copper particles dispersed in 1 × 10⁶ times by mass of ethanol, as measured by a spectrophotometer, has an absorption peak in a range of wavelengths of from 600 to 1000 nm.

Such a light absorption characteristic of the copper particle makes it possible to provide a paste composition capable of forming a bonding layer having high denseness, high bonding strength, and high bonding reliability.

Correlation between the reason why the paste composition of the present disclosure can form a bonding layer having high denseness, high bonding strength, and high bonding reliability and the light absorption characteristic described above is not clear. It is presumed that the main factor for the reason is a shape of the copper particle, and that a degree of reduction of the copper oxide is also involved.

The absorption peak may be within a range of wavelengths of from 610 to 900 nm, or within a range of wavelengths of from 620 to 850 nm.
The copper particle having an absorption peak in the wavelength range is likely to exhibit a greenish color that is a complementary color of the absorption wavelength.

The absorption spectrum of the copper particle has only to have at least one absorption peak or may have two or more absorption peaks, in the range of wavelengths of from 600 to 1000 nm. In addition, an absorption peak may be present outside the range of wavelengths of from 600 to 1000 nm.

In the absorption spectrum of the copper particle, a maximum mean absorbance (A2) in a continuous 50 nm section within the range of wavelengths of from 600 to 1000 nm may be not less than 1.25 times an average value (A1) of mean absorbances in a range of wavelengths of from 400 to 450 nm.
An absorbance ratio (A2/A1) may be from 1.30 to 3.50 or may be from 1.50 to 3.00.

From the viewpoint of sufficiently dispersing the copper particles in a dispersion medium, the absorption spectrum is obtained by dispersing the copper particles in 1 × 10⁶ times by mass of ethanol to prepare a sample liquid and measuring absorbance of the sample liquid by a spectrophotometer. Specifically, the absorption spectrum can be measured by a method that will be described in the Examples.

The copper particle may be a plate-shaped particle.
The copper particle may have a thickness of from 5 to 50 nm, from 8 to 40 nm, or from 10 to 30 nm.
The copper particle may have a major axis of from 30 to 300 nm, from 50 to 200 nm, or from 75 to 150 nm, and the major axis may be larger than the thickness.

The copper particle may have an aspect ratio (major axis/thickness) of from 1.5 to 10.0, from 2.0 to 9.0, or from 3.0 to 8.0.

Since the copper particle is the plate-shaped particle as described above, a contact area between the particles is larger than that of spherical particles. It is presumed that a bonding layer formed from a paste composition including the plate-shaped particle as described above is likely to have high denseness, high bonding strength, and high bonding reliability.

Each of the thickness and major axis of the copper particle is a median of length measurement values of at least 200 particles extracted from an image captured in scanning electron microscope (SEM) observation. The thickness and major axis of the copper particle can be measured by methods that will be described in the Examples. The plate-shaped particle has a shape having a pair of substantially parallel planes, and a distance between the pair of planes is referred to as "thickness", and the longest diameter in the planes is referred to as "major axis".

The copper particle is usually sintered by heating to from 100 to 250°C in an inert gas atmosphere.
Examples of the inert gas include nitrogen, argon, and helium. From the viewpoint of availability and cost, nitrogen may be used.
A heating temperature may be from 120 to 230°C or from 150 to 200°C, from the viewpoint of sinterability.
The sintering may be performed under normal pressure or under pressure.
A heating time is appropriately set according to the heating temperature, a form of a sintered body, and the like. From the viewpoint of sufficient progress of the sintering, a sintering time may be, for example, from 5 to 180 minutes, from 10 to 120 minutes, or from 30 to 90 minutes.

### Method for Producing Oxide-Containing Copper Particle

A method for producing the oxide-containing copper particle of the present disclosure is not particularly limited. For example, a copper compound may be reduced with a reducing compound in the presence of a shape stabilizer. The copper compound, the shape stabilizer, and the reducing compound may be mixed in an organic solvent.

### Copper Compound

Examples of the copper compound include copper oxide, copper hydroxide, copper nitride, and copper carboxylate. The copper compound may be copper oxide from the viewpoint of obtaining the copper particle of the present disclosure at a high yield. The copper compounds may be used alone or in combination of two or more.

Examples of the copper oxide include copper (I) oxide (cuprous oxide: Cu₂O) and copper (II) oxide (CuO). From the viewpoint of productivity, copper (I) oxide may be used. Examples of the copper hydroxide include copper (II) hydroxide and copper (I) hydroxide. Examples of the copper nitride include copper (II) nitride and copper (I) nitride. Examples of the copper carboxylate include copper carboxylate anhydrides or copper carboxylate hydrates such as copper (I) formate, copper (I) acetate, copper (I) propionate, copper (I) butyrate, copper (I) valerate, copper (I) hexanoate, copper (I) octoate, and copper (I) decanoate, and copper (II) formate, copper (II) acetate, copper (II) propionate, copper (II) butyrate, copper (II) valerate, copper (II) hexanoate, copper (II) octoate, copper (II) decanoate, and copper (II) citrate. As the copper carboxylate, a commercially available copper carboxylate may be used. A copper carboxylate synthesized by a known method may be used. The copper carboxylate may be copper (II) acetate monohydrate from the viewpoints of availability and a production efficiency of the copper particle of the present disclosure.

### Shape Stabilizer

The shape stabilizer may be, for example, at least one selected from the group consisting of an amine compound, a carboxylic acid, and a phosphoric acid ester, or may be a combination of an amine compound and a carboxylic acid.

Due to the shape stabilizer covering at least a part of oxide-containing copper that is the copper particle of the present disclosure, the predetermined light absorption characteristic of the present disclosure is easily obtained. In addition, fluidity of a paste composition including the copper particle is improved.

Examples of the amine compound include monoamines such as dipropylamine, butylamine, dibutylamine, hexylamine, cyclohexylamine, heptylamine, octylamine, nonylamine, decylamine, 3-aminopropyltriethoxysilane, dodecylamine, oleylamine, monoethanolamine, 2-aminoethoxy-2-ethanol, 3-amino-1-propanol, 3-amino-2-propanol, 4-amino-1-butanol, 3-amino-1-hexanol, and 2-(2-aminoethoxy)ethanol; and diamines such as ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-diaminopropane, N,N'-dimethyl-1,3-diaminopropane, N,N-diethyl-1,3-diaminopropane, 1,4-diaminobutane, 1,5-diamino-2-methylpentane, 1,6-diaminohexane, N,N'-dimethyl-1,6-diaminohexane, 1,7-diaminoheptane, and 1,8-diaminooctane. The amine compounds may be used alone or in combination of two or more. The amine compound may be an amino alcohol, and the amino alcohol may have a molecular weight of not less than 80 and not more than 150.

Examples of the carboxylic acid include monocarboxylic acids such as formic acid, acetic acid, propionic acid, butyric acid, valeric acid, hexanoic acid, heptanoic acid, octanoic acid, octylic acid, nonanoic acid, decanoic acid, oleic acid, stearic acid, and isostearic acid; and dicarboxylic acids such as oxalic acid, malonic acid, succinic acid, glutaric acid, adipic acid, pimelic acid, suberic acid, azelaic acid, sebacic acid, and diglycolic acid. The carboxylic acid may be an aromatic carboxylic acid such as benzoic acid, phthalic acid, isophthalic acid, terephthalic acid, salicylic acid, or gallic acid, or may be a hydroxy acid such as glycolic acid, lactic acid, tartronic acid, malic acid, glyceric acid, hydroxybutyric acid, tartaric acid, citric acid, or isocitric acid. The carboxylic acids may be used alone or in combination of two or more. The carboxylic acid may be a monocarboxylic acid. The monocarboxylic acid may have a molecular weight of not less than 80 and not more than 150.

The phosphoric acid ester can remove an oxide film generated on a surface of the copper particle by heating in the air and can enhance the sinterability of the copper particle. Also, the phosphoric acid ester can enhance lubricity of the copper particle in the paste composition. The phosphoric acid ester may be added after a reduction reaction. Examples of the phosphoric acid ester include alkyl phosphates, polyoxyethylene alkyl ether phosphates, and polyoxyethylene alkyl phenyl ether phosphates. The phosphoric acid ester may have an acid value and an amine value each being not more than 130 mgKOH/g, not more than 120 mgKOH/g, or not more than 110 mgKOH/g. The phosphoric acid ester may have a ratio of the acid value to the amine value [acid value/amine value] of from 0 to 1.5 or from 0 to 1.2.
The acid value is determined by a method in accordance with JIS K 0070:1992, and the amine value is determined by a method in accordance with JIS K 7237:1995.

A total amount of the shape stabilizer to be used may be from 0.1 to 10 mol, from 0.5 to 8 mol, or from 1 to 5 mol with respect to 1 mol of the copper compound.
For example, when an amine compound and a carboxylic acid are used as the shape stabilizers, a blending molar ratio of the amine compound to the carboxylic acid may be from 1/5 to 5/1, from 1/3 to 3/1, or from 1/2 to 2/1.

### Reducing Compound

The reducing compound is a compound having a reducing power to reduce the copper compound, thereby releasing metallic copper, and is not particularly limited. Examples of the reducing compound include hydrazine derivatives. The reducing compounds may be used alone or in combination of two or more.

Examples of the hydrazine derivative include hydrazine monohydrate, methylhydrazine, ethylhydrazine, n-propylhydrazine, isopropylhydrazine, n-butylhydrazine, isobutylhydrazine, sec-butylhydrazine, tert-butylhydrazine, n-pentylhydrazine, isopentylhydrazine, neo-pentylhydrazine, tert-pentylhydrazine, n-hexylhydrazine, isohexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine.

An amount of the reducing compound to be used may be from 0.1 to 10 mol, from 0.5 to 5 mol, or from 0.8 to 3 mol with respect to 1 mol of the copper compound.

### Organic Solvent

The organic solvent is not particularly limited as long as it allows for performing a uniform reaction without inhibiting properties of a complex or the like generated by mixing the copper compound, the shape stabilizer, and the reducing compound. As the organic solvent, an organic solvent that exhibits compatibility with the reducing compound may be used. Examples of the organic solvent include alcohols such as 1-propanol, 2-propanol, butanol, pentanol, hexanol, heptanol, octanol, ethylene glycol, 1,3-propanediol, 1,2-propanediol, butyl cellosolve, ethyl carbitol, and butyl carbitol; and butyl carbitol acetate, ethyl carbitol acetate, and diethylene glycol diethyl ether. The organic solvents may be used alone or in combination of two or more.

When the organic solvent is used, any amount of the organic solvent to be used may be used as long as it allows uniform mixing of the copper compound, the shape stabilizer, and the reducing compound. The amount of the organic solvent to be used may be, for example, from 0.1 to 500 times by volume relative to a volume of the shape stabilizer.

The reduction reaction of the copper compound may be heated from the viewpoint of sufficient progress of the reaction. A reaction temperature may be from -20 to 140°C, from 25 to 120°C, or from 40 to 100°C. From the viewpoint of sufficient progress of the reaction, a reaction time may be from 20 to 360 minutes, from 30 to 300 minutes, or from 40 to 240 minutes.

When a content of a container in which the reduction reaction has been performed is a liquid (mixed liquid), a solid may be separated, for example, by centrifugation or the like. The obtained solid may be washed with an organic solvent, and may be obtained as a cake of copper particles by centrifugation or the like.
The washing may be performed as long as the shape stabilizer, the reducing compound, and the like are sufficiently removed, and a washing method is not particularly limited.
The organic solvent for washing may be an alcohol. Examples of the alcohol include ethanol, 1-propanol, 2-propanol, butanol, pentanol, hexanol, heptanol, octanol, ethylene glycol, 1,3-propanediol, 1,2-propanediol, diethylene glycol, butyl cellosolve, ethyl carbitol, and butyl carbitol. The organic solvents for washing may be used alone or in combination of two or more.

### Paste Composition

The paste composition of the present disclosure contains the oxide-containing copper particle of the present disclosure described above.

A content of the copper particle in the paste composition may be from 10 to 95 mass%, from 20 to 90 mass%, or from 30 to 85 mass%.

In the present disclosure, a non-volatile content, which is a component excluding the organic solvent in the paste composition, is regarded as the content of the copper particle.

The paste composition may be diluted with an organic solvent from the viewpoint of handleability, viscosity, and the like at the time of use of the paste composition.
From the viewpoint of dispersibility of the copper particle and volatility at the time of sintering of the paste composition, examples of the organic solvent include 1-propanol, 2-propanol, ethylene glycol, 1,3-propanediol, 1,2-propanediol, diethylene glycol, propylene glycol, dipropylene glycol, 1,4-butanediol, 3-methyl-1,5-pentanediol, glycerin, and polyethylene glycol. These organic solvents may be used alone or in combination of two or more. The organic solvent for dilution may be the same as the organic solvent for washing the copper particle.

The paste composition of the present disclosure may appropriately contain known additives that are applied to general electrically conductive pastes, if necessary, in addition to the copper particle, the organic solvent, and components derived from the production of the copper particle.
Examples of the additive include a thermosetting resin, a curing accelerator, stress reducing agents such as rubber and silicone, a coupling agent, an antifoaming agent, a surfactant, coloring agents such as a pigment and a dye, a polymerization inhibitor, and an antioxidant. These additives may be used alone or in combination of two or more.

The paste composition of the present disclosure can be prepared by kneading a mixture of the copper particle, the organic solvent, and the additive used as necessary with a kneading machine such as a disperser, a kneader, a three-roll mill, or a planetary mixer, and defoaming the kneaded product.

A cured product of the paste composition of the present disclosure includes a sintered body of the copper particles of the present disclosure, and has high thermal conductivity and high heat dissipation properties. Therefore, when the paste composition of the present disclosure is used as a bonding material for an element, a substrate of a heat dissipating member or the like, thermal conductivity of a device is improved, and dissipation properties of heat inside the device to the outside is improved. Therefore, use of the paste composition of the present disclosure makes it possible to stabilize operability of various products such as semiconductor devices, electrical components, and electronic components.

### Semiconductor Device

The semiconductor device of the present disclosure is at least partially bonded by using the paste composition of the present disclosure described above. Examples of the semiconductor device include semiconductor devices in which a semiconductor element and a substrate serving as an element support member are bonded by using the paste composition. The paste composition may be used as a die bond.

Due to the use of the paste composition of the present disclosure for bonding, a bonding layer having high denseness and high bonding strength is formed. Since the bonding layer has a low rate of change in thermal resistance and high bonding reliability even when subjected to repeated temperature changes, a semiconductor device having stable operability can be obtained.

The semiconductor element may be a known semiconductor element, and examples thereof include transistors, diodes, wide bandgap semiconductor elements such as SiC and GaN, and light-emitting elements such as LEDs.
Examples of the element support member include a copper plate, a silver-plated copper plate, a pre-plated leadframe (PPF) plated with Ni/Pd, Ti/Pd/Au, Ni/Pd/Au, or the like, a glass epoxy plate, and a ceramic member.

The bonding strength of the bonding layer formed by using the paste composition for bonding may be not less than 20 MPa, not less than 30 MPa, or not less than 40 MPa from the viewpoint of sufficient bonding strength, though depending on the purpose of and target for bonding.
The bonding strength is die shear strength, and can be specifically measured by a method that will be described in the Examples.

The denseness of the bonding layer may be not less than 78%, not less than 80%, or not less than 82% from the viewpoint of bonding strength and bonding reliability.
The denseness is a proportion of a sintered body portion in the bonding layer, and specifically can be measured by a method that will be described in the Examples.

### Electrical Component and Electronic Component

The electrical component or the electronic component of the present disclosure is at least partially bonded by using the paste composition of the present disclosure described above. Examples of the electrical component or the electronic component include electrical components or electronic components in which a heat generating member and a heat dissipating member are bonded to each other by using the paste composition described above. The paste composition may be used as an adhesive for the heat dissipating member.

Due to the use of the paste composition of the present disclosure for bonding, a bonding layer having high denseness and high bonding strength is formed. Since the bonding layer has a low rate of change in thermal resistance and high bonding reliability even when subjected to repeated cooling and heating cycle (heat cycle) loads, it has high heat dissipation properties, can reduce temperature rise of the heat generating member, and can provide an electrical or electronic component having stable operability.

Examples of the heat generating member include optical pickups and power transistors. The heat generating member may be the semiconductor element or a member having the semiconductor element.
In addition, examples of the heat dissipating member include heat sinks and heat spreaders. The heat generating member and the heat dissipating member may be directly adhered to each other via the paste composition, or may be indirectly adhered to each other with another member having high thermal conductivity interposed therebetween.

### EXAMPLE

The present disclosure will be specifically described through examples; however, the present disclosure is not limited in any way to these examples.

### Production of Oxide-Containing Copper Particle

The compounds used in the production of the oxide-containing copper particle of each of the Examples and the Comparative Examples are as follows.

### Copper compound

· FRC-D70: cuprous oxide; available from Furukawa Chemicals Co., Ltd.; specific surface area: 0.2 m²/g
· FRC-D30: cuprous oxide; available from Furukawa Chemicals Co., Ltd.; specific surface area: 0.5 m²/g
· FRC-05B: cuprous oxide; available from Furukawa Chemicals Co., Ltd.; specific surface area: 2.3 m²/g

### Amine Compound

· 4-Amino-1-butanol; available from Tokyo Chemical Industry Co., Ltd.
· 2-(2-Aminoethoxy)ethanol; available from Tokyo Chemical Industry Co., Ltd.
· 6-Amino-1-hexanol; available from Tokyo Chemical Industry Co., Ltd.
· 3-Amino-1-propanol; available from Tokyo Chemical Industry Co., Ltd.
· n-Octylamine; available from Tokyo Chemical Industry Co., Ltd.

### Carboxylic Acid

· Hexanoic acid; available from Tokyo Chemical Industry Co., Ltd.
· Octanoic acid; available from Tokyo Chemical Industry Co., Ltd.
· Acetic acid; available from Tokyo Chemical Industry Co., Ltd.
· Decanoic acid; available from Tokyo Chemical Industry Co., Ltd.

### Reducing Compound

· Hydrazine monohydrate; available from FUJIFILM Wako Pure Chemical Corporation Organic Solvent
· 1-Propanol; available from Tokyo Chemical Industry Co., Ltd.
· Ethanol; available from Tokyo Chemical Industry Co., Ltd.
· Diethylene glycol: available from Tokyo Chemical Industry Co., Ltd.

### Example 1

10 mmol of Cuprous oxide (FRC-D70), 20 mmol of 4-amino-1-butanol, 20 mmol of hexanoic acid, 10 mmol of hydrazine monohydrate, and 400 mL of 1-propanol were placed in a 2000 mL volume round-bottomed flask, heated in an oil bath at 80°C while stirring at 250 rpm, and mixed for 180 minutes. The obtained mixed liquid was centrifuged (25°C, 10000 rpm, 15 minutes; hereinafter, the same conditions), and the supernatant liquid was removed. Ethanol was added to the residue, and the mixture was stirred and washed for 10 minutes with a vacuum planetary centrifugal mixer (25°C, 1000 rpm), and then centrifuged, and the supernatant liquid was removed. This operation was repeated four times. Furthermore, ethanol was changed to diethylene glycol, and the same operation as the above-described washing, centrifugation, and removal of the supernatant liquid was repeated twice to obtain an oxide-containing copper particle cake.

### Examples 2 to 4 and Comparative Examples 1 and 2

Each oxide-containing copper particle cake was obtained by the same operation as in Example 1 except that the raw material components shown in Table 1 were used.

Measurement and Evaluation of Oxide-Containing Copper Particle The oxide-containing copper particles (cakes) produced in the Examples and the Comparative Examples were subjected to the following measurement and evaluation. The evaluation results are shown in Table 1.

### Absorbance Measurement

The oxide-containing copper particle cake was collected in a sample bottle, and ethanol was added in an amount of 1 × 10⁶ times the mass of the oxide-containing copper particle. The sample bottle was immersed in an ultrasonic washer for 10 minutes for dispersion treatment, and a dispersion (sample liquid) of the oxide-containing copper particles in ethanol was prepared.

With respect to this sample liquid, absorbances at wavelengths of from 300 to 1000 nm were measured by a spectrophotometer (ultraviolet visible near infrared spectrophotometer "V-570", available from JASCO Corporation).

In Examples 1 to 4, one absorption peak was present in a range of wavelengths of from 600 to 1000 nm. In Comparative Examples 1 and 2, no peak was present in the range of wavelengths from 600 to 1000 nm.

In addition, an average value (A1) of mean absorbances in a range of wavelengths of from 400 to 450 nm and a maximum mean absorbance (A2) in a continuous 50 nm section within the range of wavelengths of from 600 to 1000 nm were determined, and an absorbance ratio (A2/A1) between them was calculated.

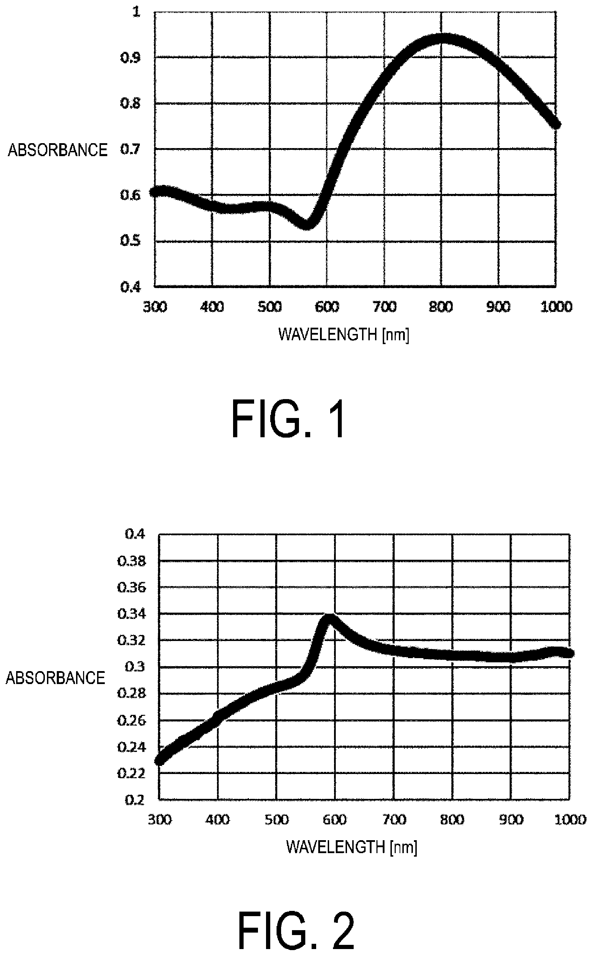

Absorption spectra for Example 4 and Comparative Example 2 are shown in FIGs. 1 and 2, respectively, as representative examples.

### Scanning Electron Microscope (SEM) Observation

The oxide-containing copper particle cake was applied to a brass sample stand to which a carbon tape was attached, and dried at 90°C for 3 hours in a nitrogen atmosphere, and a sample was produced.

This sample was observed with an SEM (Schottky field emission scanning electron microscope "JSM-F100", available from JEOL Ltd.; acceleration voltage: 15 kV, magnification: 100000 times; the same applies hereinafter). The lengths of 200 particles in an SEM image were measured, and the thicknesses and the major axes of the particles were determined. Table 1 indicates medians of the thicknesses and the major axes.

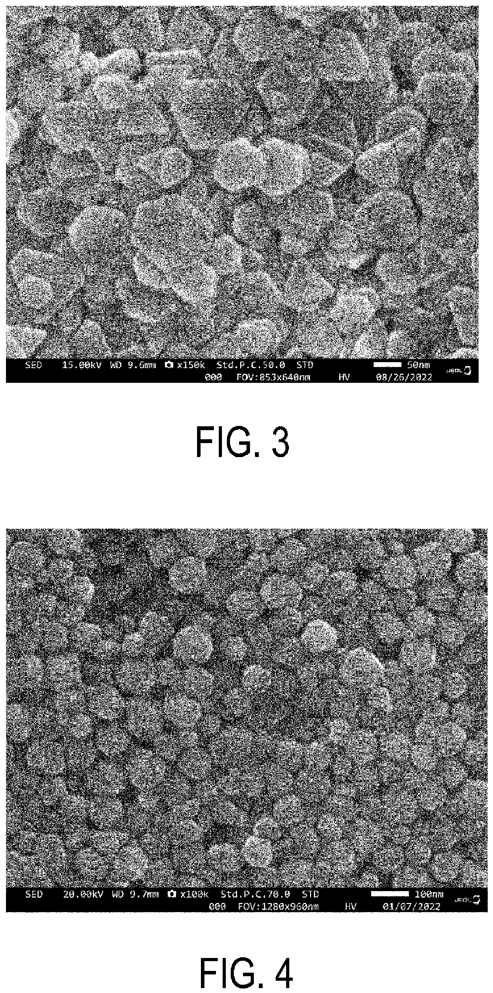

The SEM images of Example 4 and Comparative Example 2 are shown in FIGs. 3 and 4, respectively, as representative examples.

### Characteristic Evaluation of Sintered Body

The sintered bodies of the oxide-containing copper particles produced in the Examples and the Comparative Examples were subjected to the following measurement and evaluation. These evaluation results are also shown in Table 1.

### Bonding Strength

The oxide-containing copper particles (cakes) produced in the Examples and the Comparative Examples were diluted with diethylene glycol, and paste compositions having a non-volatile content of 80 mass% were prepared.

Using the prepared paste compositions, a Ti/Pd/Au-plated aluminum nitride piece (3 mm × 3 mm, 200 µm thick) was adhered to a Ni/Pd-plated copper substrate, and heating was performed at 200°C for 60 minutes in a nitrogen atmosphere (containing 3 vol% of hydrogen) to sinter the copper particles, and bonding test pieces (test pieces without a sealing resin) were produced.

The die shear strength (bonding strength) of each of the bonding test pieces was measured by using a bonding strength tester ("4000Plus Bond Tester", available from Nordon DAGE; room temperature (25°C), distance from the substrate to the loading fixture: 0.15 mm, loading rate: 30 mm/min).

### Denseness

The test piece without the sealing resin was embedded in an epoxy resin and cut in the thickness direction to obtain a sample. The sample was observed using SEM, and an area proportion of a sintered body portion in a binarized image of a cross section of the bonding layer was determined, and defined as the denseness.

### Cooling and heating cycle test

Using the paste composition, a Ti/Au-plated silicon chip (3 mm × 3 mm, 200 µm thick) was adhered to a Ni/Pd/Au-plated die pad (4 mm × 4 mm) of a QFP (Quad Flat Package) frame and heated at 200°C for 60 minutes in a nitrogen gas atmosphere (containing 3 vol% of hydrogen), and the copper particles were sintered. The sintered product was mold-sealed with an epoxy resin for sealing ("KE-G3000D", available from KYOCERA Corporation), and a bonding test piece (a test piece with the sealing resin) was produced.

A cooling and heating cycle test (1 cycle: from -40°C to 120°C/30 minutes, 2000 cycles) was performed on the test piece without the sealing resin and the test piece with the sealing resin. The rate of change in thermal resistance of the bonding portion before and after the test was measured by a transient thermal resistance measuring device ("Simcenter T3Ster", available from Siemens K.K.). Table 1 shows the rate of change in thermal resistance. A lower rate of change indicates a higher bonding reliability. When the rate of change exceeded 10%, the bonding reliability was low and evaluated as poor.

### [Table 1]

**Table 1**

| | | | Example 1 | Example 2 | Example 3 | Example 4 | Comparative Example 1 | Comparative Example 2 |
|---|---|---|---|---|---|---|---|---|
| Raw material component [mmol] | | | | | | | | |
| | Cuprous oxide (FRC-D70) | | 10 | - | 10 | 10 | - | - |
| Copper compound | Cuprous oxide (FRC-D30) | | - | 10 | - | - | - | - |
| | Cuprous oxide (FRC-05B) | | - | - | - | - | 10 | 10 |
| Amine compound | 4-Amino-1-butanol | | 20 | - | - | - | - | - |
| | 2-(2-Aminoethoxy)ethanol | | - | 20 | 20 | - | - | - |
| | 6-Amino-1-hexanol | | - | - | - | 20 | - | - |
| | 3-Amino-1-propanol | | - | - | - | - | 20 | - |
| | n-Octylamine | | - | - | - | - | - | 20 |
| Carboxylic acid | Hexanoic acid | | 20 | | - | - | - | - |
| | Octanoic acid | | - | 20 | 20 | 20 | - | - |
| | Acetic acid | | - | - | - | - | 20 | - |
| | Decanoic acid | | - | - | - | - | - | 20 |
| Reducing compound | Hydrazine monohydrate | | 10 | 10 | 10 | 10 | 10 | 10 |
| Evaluation | | | | | | | | |
| Copper particle | Absorption peak wavelength [nm] | | 633 | 641 | 695 | 805 | 576 | 579 |
| | Absorbance ratio (A2/A1) | | 1.42 | 1.32 | 2.77 | 1.65 | 1.16 | 1.24 |
| | Thickness [nm] | | 19 | 25 | 11 | 18 | 202 | 72 |
| | Major axis [nm] | | 80 | 92 | 81 | 117 | 202 | 72 |
| Bonding strength [MPa] | | | 41 | 45 | 70 | 76 | 15 | 10 |
| Denseness [%] | | | 84 | 85 | 88 | 89 | 75 | 72 |
| Rate [%] of change in thermal resistance (Cooling and heating cycle test) | | Without sealing resin | 7 | 5 | 2 | 2 | 125 | 186 |
| | | With sealing resin | 5 | 2 | 1 | 1 | 113 | 186 |

The oxide-containing copper particles (Examples 1 to 4) in which an absorption spectrum had an absorption peak in a range of wavelengths from 600 to 1000 nm were plate-shaped particles (see FIG. 3), whereas the copper particles (Comparative Examples 1 and 2) in which an absorption spectrum had no absorption peak in the range of wavelengths had a substantially spherical particle shape (see FIG. 4).
It was found that the paste compositions of Examples 1 to 4 can form a bonding layer having high denseness, high bonding strength, and high bonding reliability.

## Claims

1. An oxide-containing copper particle, in which an absorption spectrum of the oxide-containing copper particles dispersed in 1 × 10⁶ times by mass of ethanol, as measured by a spectrophotometer, has an absorption peak in a range of wavelengths of from 600 to 1000 nm.

2. The oxide-containing copper particle according to claim 1, wherein, in the absorption spectrum, a maximum mean absorbance in a continuous 50 nm section within the range of wavelengths of from 600 to 1000 nm is not less than 1.25 times an average value of mean absorbances in a range of wavelengths of from 400 to 450 nm.

3. The oxide-containing copper particle according to claim 1 or 2, wherein the oxide-containing copper particle has a thickness of from 5 to 50 nm and a major axis of from 30 to 300 nm, and the major axis is larger than the thickness.

4. A paste composition comprising the oxide-containing copper particle according to any one of claims 1 to 3.

5. A semiconductor device which is at least partially bonded by using the paste composition according to claim 4.

6. An electrical component which is at least partially bonded by using the paste composition according to claim 4.

7. An electronic component which is at least partially bonded by using the paste composition according to claim 4.
